# EUROPÄISCHE PATENTSCHRIFT

(11) **EP 1 796 451 B1**
(45) Veröffentlichungstag und Bekanntmachung des Hinweises auf die Patenterteilung: **16.03.2011**
(21) Anmeldenummer: 06123527.1
(22) Anmeldetag: 06.11.2006
(51) Int. Cl.: H05K 13/00

(54) **Stützstift zum Unterstützen eines mit elektrischen Bauteilen zu bestückenden Substrats**
Support pin for supporting a substrate populated with electric components
Broche de support pour un substrat, sur lequel sont montés des composants électrique

(30) Priorität: 12.12.2005 DE 102005059267
(43) Veröffentlichungstag der Anmeldung: 13.06.2007
(73) Patentinhaber: Siemens Electronics Assembly Systems GmbH & Co. KG, 81379 München (DE)
(72) Erfinder: Mehdianpour, Mohammad, 81829, München (DE); Rauch, Robert, 82327, Tutzing (DE)
(74) Vertreter: Maier, Daniel Oliver

(56) Entgegenhaltungen:
- EP-A- 0 929 209
- EP-A- 1 178 716
- EP-A- 1 178 717
- EP-A2- 1 178 715
- DE-A1- 10 019 231
- JP-A- 7 015 189
- US-A1- 2004 055 149

## Beschreibung

Die Erfindung betrifft einen Stützstift zur Unterstützung eines Substrats, welches mit elektrischen Bauteilen zu bestücken ist.

In der Bestücktechnik werden Substrate in einem so genannten Bestückautomaten mit elektrischen Bauteilen bestückt. Die Substrate werden dabei mittels einer geeigneten Transportstrecke zu den Bestückpositionen des Bestückautomaten transportiert, wo sie von einem verfahrbaren Bestückkopf mit Bauteilen versehen werden. Um das Substrat gegen Durchbiegen während des Bestückvorgangs abzustützen, werden diese an ihrer Unterseite durch geeignete Stützvorrichtungen abgestützt. Derartige Stützvorrichtungen weisen meist mehrere Stützstifte auf.

Aus der Offenlegungsschrift WO-01/06823 A1 ist ein höhenverstellbarer Stützstift zur Unterstützung von Substraten bekannt, der aus einem Fußteil und einer gegenüber dem Fußteil federnd gelagerten Spitze besteht. Beim Heranfahren der Stützstifte gegen die Unterseite des Substrats passen sich die Stützstifte individuell an die Kontur des Substrats an. Anschließend wird die sich einstellende Höhenposition der Stützstifte durch eine pneumatische Bremse fixiert. Dadurch sollen unterschiedlich gewölbte Substrate gegen das Durchbiegen beim Aufsetzen der Bauelemente gesichert werden.

Aus dem Patent Abstract of Japan JP-07022794 ist eine Stützvorrichtung bekannt, bei der eine Mehrzahl von Stützstiften verschieblich in Vertiefungen einer Bodenplatte gelagert sind. Die Stützstifte werden mittels Überdruck von unten an ein Substrat angenähert, wo sie sich mittels eines mit Vakuum beaufschlagten Saugnapfes festsaugen. In dieser Position werden die angesaugten Stützstifte in der Bodenplatte festgeklemmt und fixiert.

Die zu bestückenden Substrate weisen meist unterschiedlich starke Wölbungen auf. Aus obiger Ausführung geht hervor, dass sich die aus dem Stand der Technik bekannten Stützstifte bzw. Stützvorrichtungen an die Wölbung des Substrats anpassen. Das Substrat wird demnach im gewölbten Zustand fixiert und bestückt. Da sich der Bestückkopf während des Bestückens in einer horizontalen Ebene über der Substratoberfläche bewegt, ergeben sich durch die Wölbung, je nach Bestückposition, unterschiedliche Abstände zwischen der Substratoberfläche und dem Bestückkopf. Somit variiert die Aufsetzkraft, mit der die Bauteile auf der Substratoberfläche aufgesetzt werden, aufgrund der Wölbung in Abhängigkeit von der Position über dem Substrat. Dadurch kann es zu Störungen beim Bestückprozess kommen, wie beispielsweise einer unzureichenden Aufsetzkraft, was zum Verlust des Bauteils führen kann, oder einer zu starken Aufsetzkraft, was zu einer Zerstörung des Bauteils führen kann.

Ein Stützstift mit den Merkmalen den ersten Teils des Anspruchs 1 ist aus EP-A-1 178 715 bekannt.

Es ist deshalb die Aufgabe der vorliegenden Erfindung, einen Stützstift, mit welcher die Prozess-Sicherheit des Bestückvorganges gesteigert werden kann.

Diese Aufgabe wird durch den Stützstift gemäß dem unabhängigen Anspruch gelöst. Vorteilhafte Ausgestaltungen sind Gegenstand der Unteransprüche.

Ein Stützstift gemäß dem Anspruch 1 umfasst einen stabförmigen Grundkörper mit einer ersten Öffnung, über die der Grundkörper an eine Vakuumversorgung anschließbar ist, und eine zweite Öffnung, welche an einem Ende des Grundkörpers angeordnet ist und mit der ersten Öffnung pneumatisch gekoppelt ist. Der Stützstift weist ferner einen kontrahierbaren Saugstutzen zum Ansaugen des Substrats auf, welcher an dem Ende des Grundkörpers mit der zweiten Öffnung angeordnet und dort befestigt ist. Der Saugstutzen ist derart ausgebildet, dass er in einem freien Zustand über das Ende des Grundkörpers hinausragt und in einem Ansaugzustand, in dem das Substrat angesaugt ist, derart in Richtung des Endes des Grundkörpers kontrahiert ist, dass das Substrat an dem Ende des Grundkörpers anliegt. Bei einem derartigen Stützstift passt sich der kontrahierbare Saugstutzen im freien Zustand bei Kontakt mit dem Substrat zunächst der Wölbung des Substrats an. Bei Aktivierung der Vakuumversorgung bzw. beim Ansaugen kontrahiert der Saugstutzen durch die Evakuierung seines Innenraums in Richtung des Endes des Grundkörpers. Gleichzeitig wird das an dem Saugstutzen angesaugte Substrat bei der Kontraktion ebenfalls in Richtung des Endes des Grundkörpers bewegt. Das Ende des Grundkörpers stellt jedoch einen Anschlag für das Substrat dar. Somit liegt das Substrat im Ansaugzustand am Ende des Grundkörpers fest an. Sind mehrere gleichartige Stützstifte zur Unterstützungen des Substrats vorgesehen, so wird die Wölbung des Substrats dadurch egalisiert, dass das Substrat nach dem Ansaugen an dem Ende eines jeden Stützstiftes fest anliegt und dadurch eine ebene Fläche bildet. Dadurch wird erreicht, dass der Abstand zwischen dem Bestückkopf und dem Substrat beim Bestücken einheitlich ist und die wirkenden Aufsetzkräfte wesentlich genauer vorausberechenbar und einstellbar sind. Ein Verlust von Bauteilen durch zu geringe Aufsetzkräfte oder ein Zerstören von Bauteilen durch zu hohe Aufsetzkräfte wird vermieden.

Darüberhinaus ist der Saugstutzen derart am Ende des Grundkörpers angeordnet, dass das Ende des Grundkörpers mit der zweiten Öffnung in einen durch den Saugstutzen ausgebildeten Hohlraum bzw. Innenraum hineinragt. Die zweite Öffnung ist dabei derart ausgebildet, dass der Hohlraum selbst im Ansaugzustand über die zweite Öffnung mit der Vakuumversorgung pneumatisch gekoppelt ist. Durch diese Ausgestaltung wird gewährleistet, dass der durch den Saugstutzen definierte Hohlraum selbst im Ansaugzustand ständig evakuiert wird, so dass das Substrat sicher angesaugt bleibt und am Ende des Grundkörpers anliegt. Dadurch ist eine sichere Fixierung des Substrats während des Bestückvorganges möglich.

Der Stützstift kann gemäß Anspruch 2 auch dahingehend ausgestaltet werden, dass der Saugstutzen als elastischer Balg, beispielsweise aus elastomerem Material, ausgebildet ist. Ein derartiger Saugstutzen passt sich sehr flexibel an die Wölbung des Substrats an und ist gleichzeitig sehr kostengünstig.

Der Stützstift kann gemäß einer Ausgestaltung nach Anspruch 3 auch einen Standfuß aufweisen, an welchem der Grundkörper befestigt ist. Der Grundkörper und der Standfuß sind dabei relativ zueinander derart arrangiert, dass das Ende des Grundkörpers mit der zweiten Öffnung in der senkrechten Projektion auf die Standfläche des Standfußes außerhalb des Zentrums dieser Standfläche befindet. Eine derartige Ausgestaltung des Stützstiftes erlaubt eine sehr flexible Variation der Abstände der Enden der Grundkörper relativ zueinander. Dadurch kann die Platzierung der Stützstifte gut an die Topographie des Substrats, insbesondere an schon einseitig bestückte Substrate, angepasst werden.

Gemäß Anspruch 4 handelt es sich beim dem Standfuß um einen Magnetfuß. Dadurch lässt sich der Stützstift sehr schnell auf einer entsprechenden Grundfläche positionieren.

Im Folgenden wird ein vorteilhaftes Ausführungsbeispiel für den erfindungsgemäßen Stützstift mit Bezug auf die beigefügten Figuren näher erläutert. In den Figuren sind:
Figur 1a eine Darstellung eines Ausführungsbeispiels des Stützstiftes im freien Zustand;
Figur 1b eine Draufsicht des Stützstiftes in Figur 1a
Figur 1c eine Darstellung des Stützstiftes im Ansaugzustand; Figur 2a und Figur 2b Darstellungen einer Stützvorrichtung mit Stützstiften im freien Zustand sowie im Ansaugzustand.

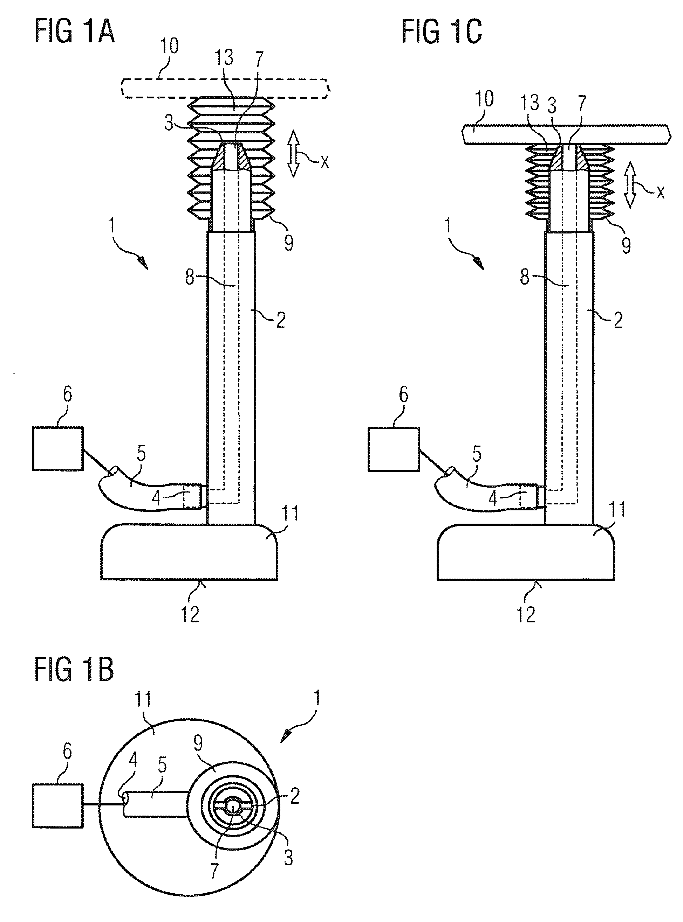

In den Figuren 1a, 1b und 1c ist ein Ausführungsbeispiel eines Stützstiftes 1 dargestellt, wobei Fig. 1b eine Draufsicht des in Fig. 1a dargestellten Stützstiftes 1 ist. Der Stützstift 1 weist einen stabförmigen Grundkörper 2 auf, welcher im Falle des Ausführungsbeispiels die Form eines lang gestreckten und an einem freien Ende 3 spitz zulaufenden Zylinders aufweist. An dem Grundkörper 2 ist eine erste Öffnung 4 ausgebildet, über die der Grundkörper 2 beispielsweise über eine entsprechende Schlauchleitung 5 mit einer Vakuumversorgung 6 koppelbar ist. An dem freien Ende 3 weist der Grundkörper 2 eine zweite Öffnung 7 auf, welche über einen im Grundkörper 2 verlaufenden Kanal 8 mit der ersten Öffnung 4 pneumatisch gekoppelt ist. Bei Betrieb der Vakuumversorgung 6 liegt somit an der zweiten Öffnung 7 ein Unterdruck an, wodurch eine Saugwirkung entsteht.

Der Stützstift 1 umfasst ferner einen kontrahierbaren Saugstutzen 9, im Ausführungsbeispiel in Form eines elastischen Gummibalgs, welcher im Bereich des Endes 3 des Grundkörpers 2 unterhalb der zweiten Öffnung 7 am Grundkörper 2 befestigt ist. Der elastisch kontrahierbare Saugstutzen 9 ist derart ausgebildet, dass er sich bei Belastung, beispielsweise beim Aufliegen eines Substrats 10 (in Fig. 1a gestrichelt dargestellt), in Richtung x des Endes 3 des Grundkörpers 2 elastisch zusammenstaucht und bei Entlastung wieder eine ursprüngliche Ausdehnung einnimmt. In dem freien Zustand ragt das freie Ende 3 des Saugstutzens 9 über das Ende 3 des Grundkörpers 2 hinaus, wie es Fig. 1a dargestellt ist.

Der Stützstifte 1 weist ferner einen Standfuß 11 auf, an welchem der Grundkörper 2 befestigt ist. Bei dem Standfuß 11 kann es sich, wie hier im Ausführungsbeispiel, um einen Magnetfuß 11 handeln, welcher auf einer entsprechenden metallischen Oberfläche lösbar angeordnet werden kann. Wie in den Fig. 1a bis 1c gezeigt ist, kann der Grundkörper 2 derart am Standfuß 11 angeordnet sein, dass sich das Ende 3 des Grundkörpers 2 in der senkrechten Projektion auf eine Standfläche 12 des Standfußes 11 außerhalb des Zentrums der Standfläche 12 befindet (siehe Fig. 1b). Dies bringt den Vorteil, dass die Abstände der zweiten Öffnungen 7 zweier nebeneinander platzierter Stützstifte 1 variierbar sind.

Wie anhand der Figuren 1a und 1c deutlich wird, wird durch den zylindrisch ausgeformten Saugstutzen 9 bzw. Saugbalg 9 ein Hohlraum 13 ausgebildet, in den das Ende 3 des Grundkörpers 2 mit der zweiten Öffnung 7 hineinragt. Wird nun die Vakuumversorgung 6 aktiviert, entsteht auch in diesem Hohlraum 13 ein Unterdruck, was eine Saugwirkung am offenen freien Ende 3 des Saugstutzens 9 bewirkt. Wird nun ein Substrat 10 mit dem freien Ende 3 des Saugstutzens 9 in Kontakt gebracht, so passt sich der elastische Saugstutzen 9 an die ihm zugewandte Oberfläche des Substrats 10 an und saugt sich fest. Da dadurch über das freie Ende 3 des Saugstutzens 9 keine Luft mehr von außen in den Hohlraum 13 strömen kann, wird dieser Hohlraum 13 immer weiter evakuiert, was zur Folge hat, dass sich der Saugstutzen 9 mit dem Substrat 10 in Richtung des Endes 3 des Grundkörpers 2 elastisch kontrahiert. Diese Kontraktionsbewegung endet genau dann, wenn das Substrat 10 an dem Ende 3 des Grundkörpers 2 anschlägt und dort anliegt. Dieser Zustand wird hier als Ansaugzustand bezeichnet, wie er in Fig. 1c dargestellt ist. In diesem Ansaugzustand ist das Substrat 10 einerseits nach unten bzw. in Richtung des Stützstiftes 1 gegen Durchbiegen gesichert. Andererseits ist das Substrat 10 auch ausreichend gegen vertikale Verschiebungen und Durchbiegung in der vom Stützstift 1 abgewandten Richtung durch die Saugwirkung gesichert.

Die zweite Öffnung 7 ist derart ausgebildet, dass der vom Saugstutzen 9 gebildete Hohlraum 13 selbst im Ansaugzustand über die zweite Öffnung 7 mit der Vakuumversorgung 6 pneumatisch gekoppelt ist. Im Ausführungsbeispiel ist dies dadurch realisiert, dass die zweite Öffnung 7 seitlich geschlitzt ausgeführt wird (siehe Fig. 1a bis 1c).

Dadurch wird der Hohlraum 13 selbst im Ansaugzustand weiter evakuiert, wodurch das Substrat 10 sicher gehalten wird. Nach dem Abschalten der Vakuumversorgung 6 wird der Saugeffekt aufgehoben und das Substrat 10 wieder freigegeben. Nach Wegnahme des Substrats 10 bzw. der Entlastung des Saugstutzens 9 nimmt dieser wieder den freien Zustand ein (siehe Fig. la).

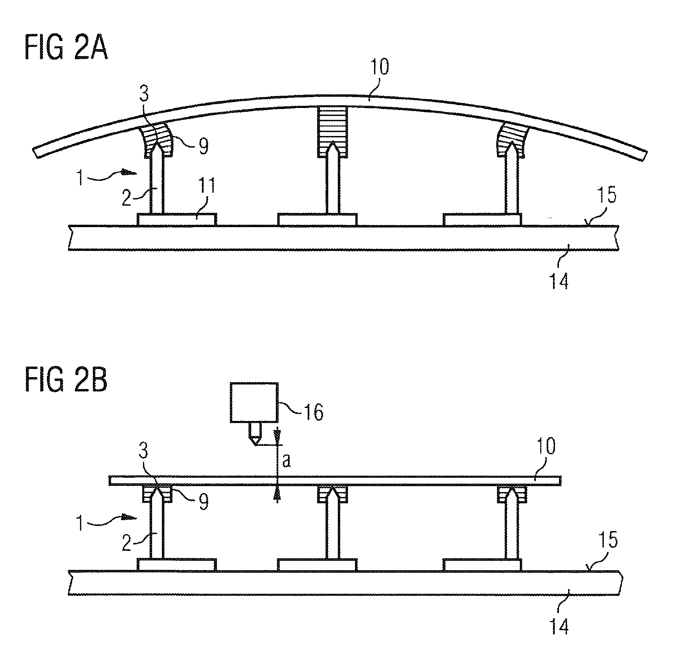

Nachfolgend wird anhand der Figuren 2a und 2b eine Stützvorrichtung beschrieben, welche zur Unterstützung von Substraten dient. Aus Gründen der besseren Übersichtlichkeit, ist die Darstellung der Stützstifte 1 in den Figuren 2a und 2b sehr schematisch und beschränkt sich auf die zur Erläuterung des Funktionsprinzips wesentlichen Merkmale.

Die Stützvorrichtung weist eine Platte 14 mit einer ebenen Grundfläche 15 auf, auf der eine Vielzahl der Stützstifte 1 mittels der Magnetfüße 11 angeordnet ist. Dadurch, dass die Stützstifte 1 mittels des Magnetfußes an beliebigen Positionen auf der Grundfläche 15 positionierbar sind, kann die Stützvorrichtung optimal an die Topologie des Substrats 10 angepasst werden, was insbesondere bei Substraten 10 vorteilhaft ist, welche auf der den Stützstiften 1 zugewandten Seite bereits bestückt sind. Diese Flexibilität wird weiter dadurch gesteigert, dass die Grundkörper 2 bzw. die Enden der Grundkörper 2 dezentral zur Standfläche 12 des zugehörigen Standfußes 11 angeordnet sind.

In Figur 2a ist eine Situation dargestellt, in der die mit den Stützstiften 1 verbundene Vakuumversorgung 6 (nicht dargestellt) noch nicht aktiviert ist. Auf die Stützstifte 1 bzw. die Saugstutzen 9 ist ein zu bestückendes Substrat 10 aufgelegt. Das Substrat 10 weist eine Wölbung auf. Dabei ist zu erkennen, dass sich die Saugstutzen 9 aufgrund ihrer Flexibilität bzw. Kontrahierbarkeit individuell an die Struktur bzw. die Wölbung des Substrats 10 anpassen können, so dass die freien Enden der Saugstutzen 9 an der ihnen zugewandten Oberflächen des Substrats 10 anliegen.

In Figur 2b ist ein Zustand dargestellt, der sich nach Einschalten der Vakuumversorgung 6 einstellt. Wie auch schon anhand der Figuren 1a und 1b verdeutlicht wurde, saugen sich die Saugstutzen 9 der Stützstifte 1 an die ihnen zugewandte Oberfläche des Substrats 10 an, woraufhin der von den Saugstutzen 9 gebildete Hohlraum 13 so weit evakuiert wird, dass sich der Saugstutzen 9 in Richtung des Endes 3 des Grundkörpers 2 kontrahiert und das Substrat 10 schließlich an den Enden der Grundkörper 2 fest anliegt. Wie aus Figur 2b hervorgeht, wird dadurch erreicht, dass die Wölbung des Substrats 10 egalisiert wird und die zu bestückende Seite des Substrats 10 eine ebene Oberfläche bildet. Das Substrat 10 ist aufgrund der Stützstifte 1 gegen Durchbiegen sowohl in einer den Stützstiften 1 zugewandten als auch einer den Stützstiften 1 abgewandten Richtung gesichert. Dadurch, dass die zu bestückende Oberfläche keinerlei Wölbung aufweist bzw. eben ist, ist der Abstand a zwischen der Oberfläche und einem Bestückkopf 16 einheitlich. Somit sind die Aufsetzkräfte besser vorausberechenbar und für jedes Bauteil einheitlich. Dadurch wird vermieden, dass die Aufsetzkräfte aufgrund der Wölbung des Substrats 10 zu groß sind, was zu einer Zerstörung des Bauteils führen kann, oder zu klein sind, was zu einem Verlust des Bauteils führen kann. Nach dem Bestücken und der Entfernung des Substrats 10 nehmen die Saugstutzen 9 wieder den freien Zustand ein (siehe Fig. 1c). Insgesamt bewirkt die erfindungsgemäße Stützvorrichtung eine deutliche Erhöhung der Sicherheit des Bestückprozesses.

### Bezugszeichenliste:

- 1: Stützstift
- 2: Grundkörper
- 3: Ende des Grundkörpers
- 4: Erste Öffnung
- 5: Schlauchleitung
- 6: Vakuumversorgung
- 7: Zweite Öffnung
- 8: Kanal
- 9: Saugstutzen
- 10: Substrat
- 11: Standfuß
- 12: Standfläche
- 13: Hohlraum
- 14: Platte
- 15: Grundfläche
- 16: Bestückkopf

## Patentansprüche

1. Stützstift (1) zum Unterstützen eines mit elektrischen Bauteilen zu bestückenden Substrats (10), mit
- einem stabförmigen Grundkörper (2) mit einer ersten Öffnung (4), über die der Grundkörper (2) an eine Vakuumversorgung (6) anschließbar ist, und einer zweiten Öffnung (7), welche an einem Ende (3) des Grundkörpers (2) angeordnet ist und mit der ersten Öffnung (4) pneumatisch gekoppelt ist, und
- einem kontrahierbaren Saugstutzen (9) zum Ansaugen des Substrats (10), welcher an dem Ende (3) des Grundkörpers (2) angeordnet ist und derart ausgebildet ist, dass er in einem freien Zustand über das Ende (3) des Grundkörpers (2) hinausragt und in einem Ansaugzustand, in dem das Substrat (10) angesaugt ist, derart in Richtung (x) des Endes (3) des Grundkörpers (2) kontrahiert ist, dass das Substrat (10) an dem Ende (3) des Grundkörpers (2) anliegt,
wobei
der Saugstutzen (9) derart am Ende (3) des Grundkörpers (2) angeordnet ist, dass das Ende (3) des Grundkörpers (2) mit der zweiten Öffnung (7) in einen durch den Saugstutzen (9) ausgebildeten Hohlraum (13) hineinragt, **dadurch gechennzeichnet, dass** die zweite Öffnung (7) derart ausgebildet ist, dass der Hohlraum (13) selbst im Ansaugzustand über die zweite Öffnung (7) mit der Vakuumversorgung (6) pneumatisch gekoppelt ist.

2. Stützstift (1) nach Anspruch 1, wobei der Saugstutzen (9) ein elastischer Balg ist.

3. Stützstift (1) nach einem der Ansprüche 1 bis 2, mit einem Standfuß (11), an welchem der Grundkörper (2) befestigt ist, wobei sich das Ende (3) des Grundkörpers (2) mit der zweiten Öffnung (7) in der senkrechten Projektion auf eine Standfläche (12) des Standfußes (11) außerhalb des Zentrums der Standfläche (12) befindet.

4. Stützstift (1) nach Anspruch 3, wobei der Standfuß (11) ein Magnetfuß (11) ist.

## Claims

1. Support pin (1) for supporting a substrate (10) to be populated with electric components, comprising
- a rod-shaped main body (2) with a first opening (4) via which the main body (2) can be connected to a vacuum supply (6), and a second opening (7) which is disposed at one end (3) of the main body (2) and pneumatically coupled to the first opening (4), and
- a contractible suction nozzle (9) for drawing in the substrate (10), said nozzle being disposed at the end (3) of the main body (2) and designed such that, in a free state, it projects beyond the end (3) of the main body (2) and, in a suction state in which the substrate (10) is drawn in, contracts in the direction (x) of the end (3) of the main body (2) such that the substrate (10) lies against the end (3) of the main body (2),
wherein
the suction nozzle (9) is disposed at the end (3) of the main body (2) such that the end (3) of the main body (2) with the second opening (7) projects into a cavity (13) formed by the suction nozzle (9), **characterized in that** the second opening (7) is designed such that, even in the suction state, the cavity (13) is pneumatically coupled to the vacuum supply (6) via the second opening (7).

2. Support pin (1) according to claim 1, wherein the suction nozzle (9) is an elastic bellows.

3. Support pin (1) according to one of claims 1 to 2, comprising a pedestal (11) on which the main body (2) is mounted, wherein, in the vertical projection onto a base area (12) of the pedestal (11), the end (3) of the main body (2) with the second opening (7) is located outside the centre of the base area (12).

4. Support pin (1) according to claim 3, wherein the pedestal (11) is a magnetic base (11).

## Revendications

1. Broche de support (1) pour soutenir un substrat (10) à équiper de composants électriques, avec
- un bâti (2) en forme de bâton avec un premier orifice (4) via lequel le bâti (2) peut être connecté à une distribution du vide (6) et un deuxième orifice (7) disposé à une extrémité (3) du bâti (2) et couplé pneumatiquement au premier orifice (4), et
- une tubulure d'aspiration contractible (9) pour aspirer le substrat (10), laquelle est disposée à l'extrémité (3) du bâti (2) et est constituée de sorte qu'elle dépasse librement de l'extrémité (3) du bâti (2) et soit, dans un état d'aspiration dans lequel le substrat (10) est aspiré, contractée de telle sorte en direction (x) de l'extrémité (3) du bâti (2) que le substrat (10) se trouve à l'extrémité (3) du bâti (2).
dans laquelle
la tubulure d'aspiration (9) est disposée de telle sorte à l'extrémité (3) du bâti (2) que l'extrémité (3) du bâti (2) s'avance avec le deuxième orifice (7) dans une cavité (13) créée par la tubulure d'aspiration (9), **caractérisée en ce que** le deuxième orifice (7) est constitué de sorte que la cavité (13)est couplée pneumatiquement à la distribution du vide (6) via le deuxième orifice (7) même en état d'aspiration.

2. Broche de support (1) selon la revendication 1, dans laquelle la tubulure d'aspiration (9) est un soufflet élastique.

3. Broche de support (1) selon l'une des revendications 1 à 2, avec un support (11) auquel le bâti (2) est fixé, dans laquelle l'extrémité (3) du bâti (2) se trouve avec le deuxième orifice (7) dans la projection verticale sur une surface de pose (12) du support (11) en dehors du centre de la surface de pose (12).

4. Broche de support (1) selon la revendication 3, dans laquelle le support (11) est un pied magnétique (11).
